(19) Europäisches Patentamt
European Patent Office
Office européen des brevets

(11) **EP 0 812 022 B1**

(12) **FASCICULE DE BREVET EUROPEEN**

(45) Date de publication et mention
de la délivrance du brevet:
**19.09.2007   Bulletin 2007/38**

(51) Int Cl.:
*H01L 31/08* *(2006.01)*      *H01L 31/108* *(2006.01)*

(21) Numéro de dépôt: **97401279.1**

(22) Date de dépôt: **06.06.1997**

(54) **Photodétecteur et générateur hyperfréquence**

Höchstfrequenzgenerator und -photodetektor

Hyperfrequency photodetector and generator

(84) Etats contractants désignés:
**DE GB IT**

(30) Priorité:  **07.06.1996  FR 9607080**

(43) Date de publication de la demande:
**10.12.1997   Bulletin 1997/50**

(73) Titulaire: **Thales**
**75008 Paris (FR)**

(72) Inventeurs:
• **Dolfi, Daniel**
**94117 Arcueil Cedex (FR)**
• **Huignard, Jean-Pierre**
**94117 Arcueil Cedex (FR)**
• **Merlet, Thomas**
**94117 Arcueil Cedex (FR)**
• **De Cremoux, Baudouin**
**94117 Arcueil Cedex (FR)**

(56) Documents cités:
**WO-A-94/09516**          **US-A- 4 695 733**

• **LAMBSDORFF M ET AL: "SUBPICOSECOND CHARACTERIZATION OF CARRIER TRANSPORT IN GAAS-METAL-SEMICONDUCTOR-METAL PHOTODIODES" APPLIED PHYSICS LETTERS, vol. 58, no. 13, 1 avril 1991, pages 1410-1412, XP000209747**
• **GIBONEY K S ET AL: "TRAVELING-WAVE PHOTODETECTORS" IEEE PHOTONICS TECHNOLOGY LETTERS, vol. 4, no. 12, 1 décembre 1992, pages 1363-1365, XP000334620**

**Description**

L'invention concerne un photodétecteur à ondes progressives permettant de fournir un signal électrique de puissance et son application à un générateur hyperfréquence. La conception du système de l'invention est basée sur la propagation d'une onde optique modulée à une fréquence déterminée et à la propagation synchrone d'un signal électrique de fréquence dans un matériau photoconducteur, ce signal électrique résultant de la détection de l'onde optique dans le photoconducteur.

Les performances des composants optoélectroniques permettent aujourd'hui la réalisation de liaisons optiques pour la transmission de signaux hyperfréquences jusqu'à des fréquences de l'ordre de 40 à 60 GHz en laboratoire. Par ailleurs, pour intégration dans des systèmes, une bande de l'ordre de 20 GHz est réalisable à partir de composants disponibles commercialement.

Ces liaisons trouvent leur application dans des systèmes comme par exemple les commandes optiques d'antennes à balayage électronique, la synchronisation de MMIC (oscillateurs, déphaseurs, ...) et les lignes à retard Pour toutes ces applications, la conversion du signal optique en signal hyperfréquence constitue un point clé de la chaîne optoélectronique. L'emploi de photodiodes rapides pour la détection des porteuses optiques des signaux micro-onde limite fortement la puissance du signal généré. En effet, la taille réduite de ces photodiodes interdit d'y focaliser une puissance optique de plus de quelques mW sans dégradation du signal transmis. Dans ce cas et sur une charge adaptée R = 50 $\Omega$, la puissance hyperfréquence obtenue est de l'ordre de -20 dBm, nécessitant dans la plupart des applications envisagées une amplification électrique d'environ 50 dB, souvent rédhibitoire.

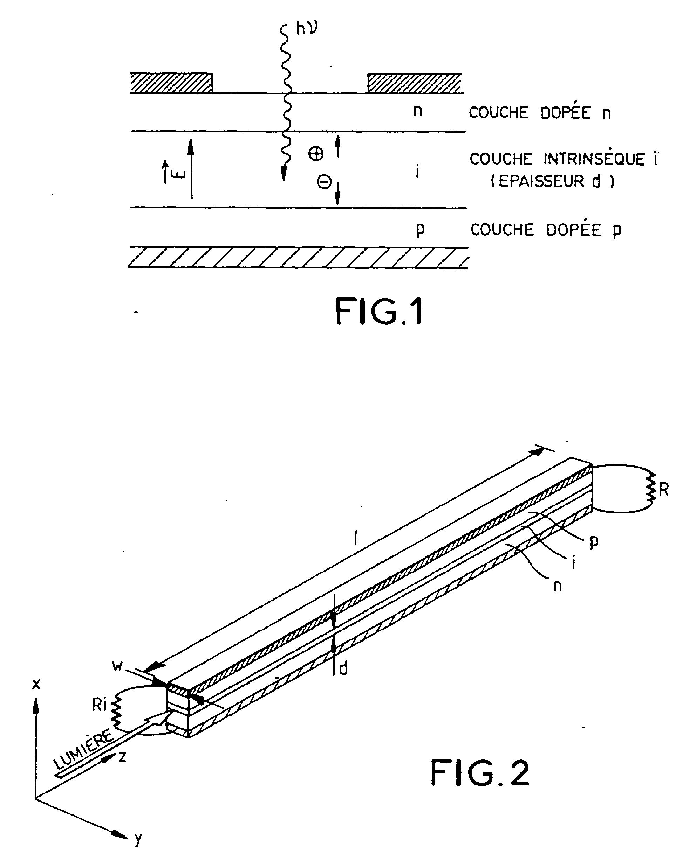

Dans le cas d'une photodiode classique pin (voir figure 1), le transport des charges photogénérées est parallèle à l'incidence du flux optique (voir figure 1). Afin de maintenir conjointement une bande passante étendue et une détectivité importante il est alors nécessaire d'établir un compromis entre l'épaisseur de la zone intrinsèque d'absorption qui détermine le temps de transit des charges $\tau_t$ et la surface sensible qui fixe la capacité équivalente C du composant. Dans ce cas l'optimum est, en première approximation, obtenu pour $\tau_t \approx RC$.

L'augmentation de la bande passante de détection à détectivité donnée ou de la puissance de saturation à bande passante fixée passe par la réalisation de photodiode guide (figure 2). Dans ce cas, en effet, le transport des charges et la propagation de l'onde optique sont orthogonaux. Ainsi l'épaisseur de la zone intrinsèque et la longueur d'absorption peuvent être optimisées séparément. Comme cela est décrit dans le document Travelling-wave photodetectors de K.S. Giboney et al, Photon. Tech. Letters 4, 1363-1365, 1992, la levée de ce compromis a permis la réalisation de photodiodes ayant une sensibilité de 0.5 A/W et une bande passante de 100 GHz.

L'augmentation de la puissance de saturation et donc du volume d'interaction dans une telle configuration se heurte au problème de la réalisation conjointe d'une guide optique et d'un guide hyperfréquence optimisés et assurant la propagation synchrone de ces deux ondes. Ainsi, à ce jour il n'existe pas d'exemple de réalisation de photodiodes dont la longueur dépasse quelques centaines de microns.

Afin de lever cette difficulté et de tirer parti d'une longueur de propagation importante, on substitue à la propagation optique guide de l'onde à détecter une propagation en espace libre. Le synchronisme des deux ondes est assuré grâce à un composant diffractif fonctionnant en transmission.

L'invention concerne donc un photodétecteur selon la revendication 1.

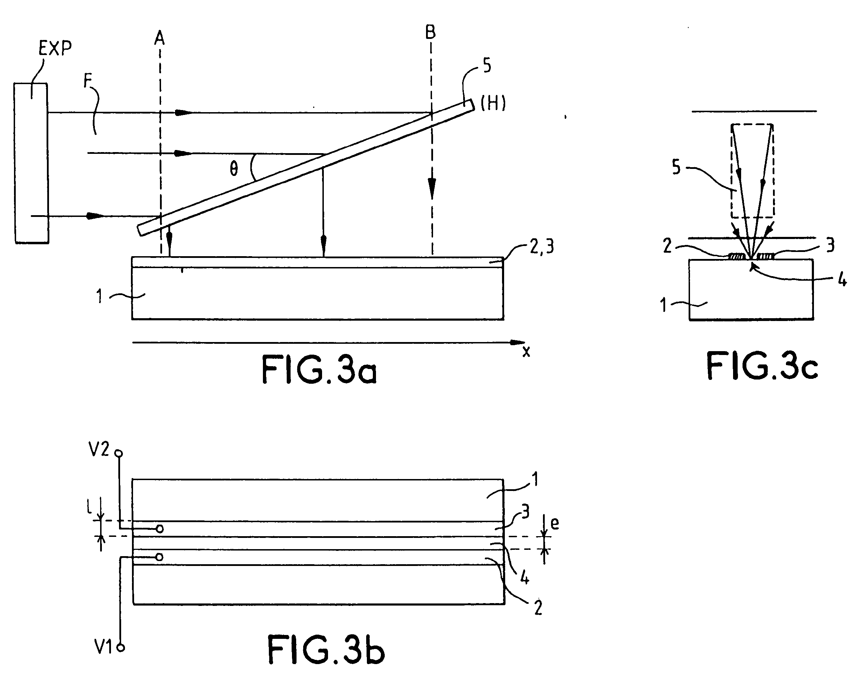

La structure proposée permet la détection de la porteuse optique d'un signal hyperfréquence. Le principe de fonctionnement du dispositif est schématisé sur les figures 3a à 3c.

Un faisceau laser F, à la longueur d'onde $\lambda$, modulé en amplitude par un signal hyperfréquence S(t) est diffracté ou réfléchi par un dispositif de diffraction ou de réflexion 5 pour l'étaler sur une face d'un dispositif en matériau photoconducteur 1. Par exemple, le dispositif 5 est un élément holographique et le faisceau diffracté est absorbé par le matériau photoconducteur 1. Ce dernier est par exemple un semiconducteur de type GaAs sur lequel ont été déposées des électrodes selon une géométrie de ligne coplanaire inverse (coplanar strip). Elles constituent ainsi un guide hyperfréquence et permettent en outre l'application d'un champ électrique uniforme et constant dans l'espace inter-électrode. Le matériau semiconducteur est plutôt de type semi-isolant et l'on choisit la nature des électrodes de manière à réaliser des structures telles un photodétecteur MSM (Métal Semiconducteur Métal) réparti ou bien une photodiode pin répartie qui sera utilisée en polarisation inverse. Ces deux types de photodétecteurs permettent d'éviter toute composante continue dans le photocourant malgré la longueur relativement importante du guide. La figure 3b représente une vue de dessus du dispositif avec ces électrodes 2, 3 sur une face du semiconducteur 1. Entre les électrodes 2, 3 se trouve une face d'éclairement. La figure 3c représente le faisceau transmis par l'élément 5 sur la face d'éclairement 4.

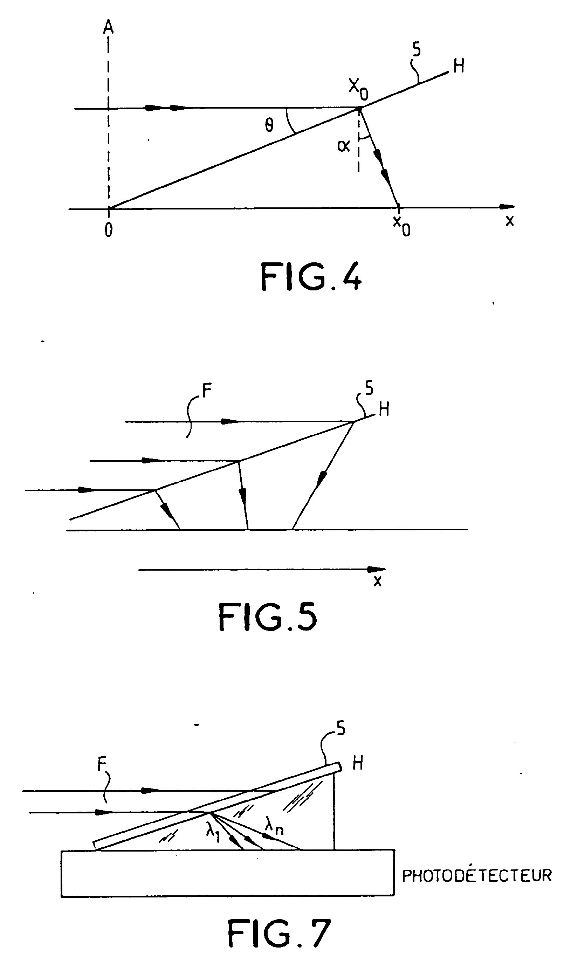

La fraction du faisceau diffractée absorbée à l'abscisse x le long du matériau photoconducteur 1 (figure 4) génère des photoporteurs. Ceux-ci sont séparés sous l'effet du champ électrique entre les électrodes reliées respectivement aux potentiels $V_1$ et $V_2$ (figure 3). Une variation de courant associée à cette génération prend naissance à l'abscisse x et se propage le long de la ligne coplanaire hyperfréquence, indifféremment suivant les x croissants et décroissants.

Afin de décrire simplement le principe de l'invention, on ne s'intéresse dans un premier temps qu'à la propagation du photocourant le long de l'axe des x (figure 3). Le faisceau laser incident dans le plan A est une onde plane à laquelle est associée une puissance optique proportionnelle à S(t). Cette onde optique est progressivement diffractée par le composant holographique 5. La fraction de l'onde diffractée à l'abscisse $X_o$ sur l'élément holographique 5 (figure 4) selon l'angle $\alpha$ a parcouru à la vitesse $v_{opt}$ un trajet optique $L_{opt}$ tel que :

$$L_{opt} = X_o (\cos \theta + \sin \theta / \cos \alpha)$$

Par ailleurs, la fraction de l'onde diffractée sur H (élément holographique 5) à l'abscisse X = 0 a donné lieu à une onde hyperfréquence dans le photodétecteur se déplaçant à la vitesse $v_{hyp}$. Si on veut, pour un signal optique modulé, que l'ensemble des photocourants élémentaires correspondent aux ondes optiques diffractées aux abscisses $X_o$, se somment en phase, il est nécessaire de respecter la condition :

$$(X_o/v_{opt}) . (\cos \theta + \sin \theta/\cos \alpha) = (X_o/v_{hyp}) . (\cos \theta + \sin \theta.\tan \alpha)$$

Du fait de l'égalité des temps de propagation optique et hyperfréquence, la longueur des guides hyperfréquence et optique n'est pas limitée et permet d'envisager un volume de détection important. Ce dernier autorise ainsi la détection d'une puissance optique élevée.

On peut noter en outre que l'angle $\alpha$ peut dépendre de l'abscisse $X_o$ de manière à autoriser une évolution de la géométrie de la ligne coplanaire (écartement e notamment) le long de x. Ainsi, une augmentation de la largeur e de la zone d'éclairement 4 susceptible d'augmenter encore le volume d'interaction le long de la propagation de l'onde hyperfréquence mais qui modifie la vitesse $v_{hyp}(x)$ peut être pris en compte au moyen d'une variation locale de l'angle $\alpha$ (voir figure 5).

L'idée de base de l'invention d'avoir une surface 4 de matériau photoconducteur de forme allongée encadrée par deux électrodes 2, 3, et soumise à un champ électrique. Un faisceau lumineux F modulé en fréquence éclaire cette surface 4. Pour cela, un dispositif EXP étend spatialement le faisceau modulé en fréquence et le transmet à la surface 4 de façon qu'en différents points de la surface 4, le faisceau lumineux est déphasé. Ce déphasage est progressif d'une extrémité de la surface 4 à l'extrémité opposée.

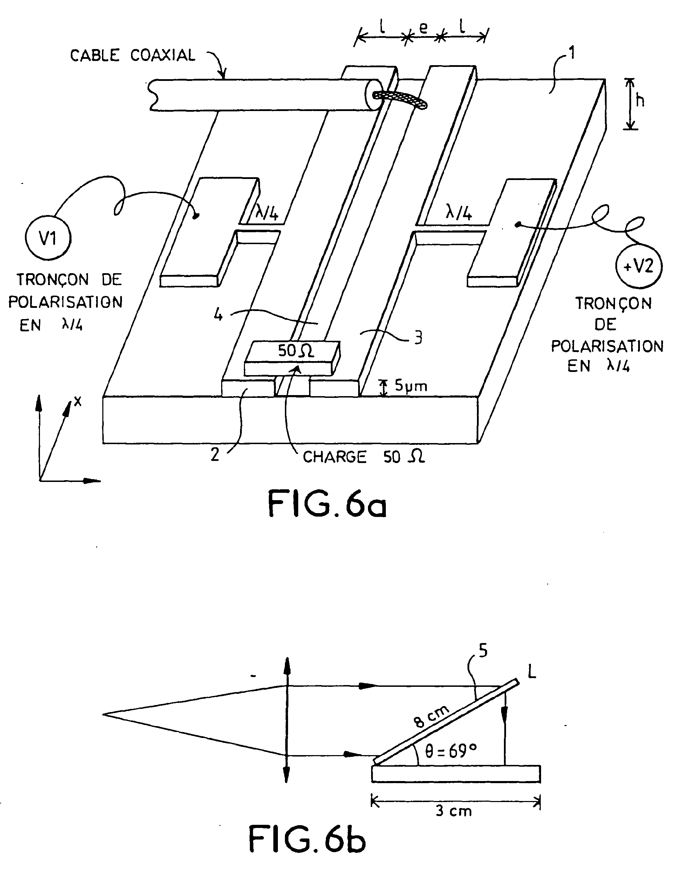

La figure 6 représente un exemple de réalisation d'un dispositif selon l'invention.

Le substrat photoconducteur, en GaAs semi-isolant d'épaisseur h = 370 $\mu$m par exemple, porte les deux électrodes 2 et 3 (en TiAu par exemple) qui délimitent la face d'éclairement 4. Une telle structure est donc du type MSM (métal/semiconducteur/métal). Les électrodes peuvent faire l'objet d'une recharge électrolytique permettant d'atteindre des épaisseurs d'électrodes de 5 $\mu$m minimisant ainsi les pertes ohmiques par effet de peau. L'écartement e des électrodes est choisi en fonction de la bande passante envisagée et la largeur des électrodes afin d'obtenir une ligne d'impédance caractéristique de 50 ohms. Ainsi, pour un fonctionnement à 2 GHz, l'écartement vaut e = 16 $\mu$m et la largeur des pistes vaut 1 = 244 $\mu$m, pour une longueur de guide d'environ 3 cm. Une charge résistive de 50 ohms placée à une des extrémités du guide (figure 6) évite les réflexions provenant des ondes hyperfréquences générées dans le sens des x décroissants. La polarisation des lignes est assurée par des tronçons à haute impédance, soit des selfs, soit des lignes à $\lambda/4$ comme indiquées sur la figure 6a. L'autre extrémité du guide est connectée à un câble coaxial. On choisit d'éclairer le photodétecteur sous incidence normale ($\alpha = 0$). L'angle de diffraction $\theta$ du réseau (voir figure 6b) doit alors respecter la condition :

$$\tan \theta = n_{hyp} - 1$$

ou $n_{hyp}$ représente l'indice hyperfréquence du semiconducteur ($\theta = 69°$ et $n_{hyp} = 3,6$ pour le GaAs).

La transmission du faisceau lumineux au dispositif photoconducteur peut utiliser tout moyen permettant son étalement sur la face 4 de façon à avoir un déphasage continu le long de la face 4.

Notamment, par des procédés classiques d'holographie sur des matériaux photopolymères, on obtient des réseaux diffractifs dont le rendement est supérieur à 90%. Des réseaux à rendement de diffraction équivalent, de type réseau blasé en transmission par exemple, sont également disponibles commercialement et peuvent être utilisés. Ce dispositif peut être réalisé à différentes longueurs d'onde notamment 1.5, 1.3, 0.85 et 0.65 $\mu$m.

La structure proposée permet d'optimiser indépendamment l'épaisseur de la zone active photoconductrice, le temps de transit des photoporteurs (largeur e) et la géométrie du guide hyperfréquence. Le compromis entre épaisseur de zone active et le temps de transit propre aux photodiodes éclairées par la surface est levé. De même, pour le compromis entre la géométrie du guide optique et celle du guide hyperfréquence propre aux photodiodes guides.

La compensation des trajets hyperfréquences par les trajets optiques permet la réalisation d'un photodétecteur à très large bande passante et potentiellement à haut niveau de saturation du fait d'un volume sensible important.

En effet, pour une fréquence de 25 GHz, une photodiode classique présente une épaisseur de 1 $\mu$m et un diamètre de 25 $\mu$m. Ce volume restreint autorise une puissance optique incidente maximale de 10 mW et délivre alors une puissance électrique limitée à quelques milliWatts. Le photodétecteur à ondes progressives selon l'invention possède pour la même fréquence d'utilisation un écartement de 1 $\mu$m, une profondeur d'absorption de typiquement 5 $\mu$m et une longueur L de quelques cm, autorisant (pour L > 1 cm) des puissances optiques incidentes supérieures au Watt. Avec une sensibilité de l'ordre de 0.5 A/W, équivalente à celle des photodiodes classiques, le système selon l'invention permettra d'avoir des puissances hyperfréquences de l'ordre du Watt.

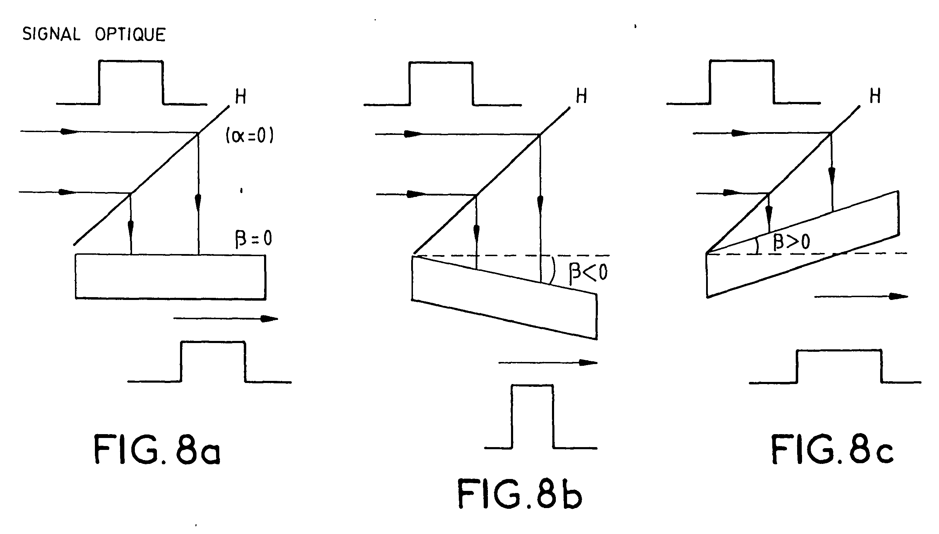

La limitation de bande passante du fait de la dispersion en fréquence du guide hyperfréquence (vhyp(f)) peut être compensée en partie par l'utilisation d'une source laser multi-longueur d'ondes et d'un matériau optique dispersif (figure 7). Dans ce cas, le dispositif de diffraction 5 est par exemple réalisé sur un prisme de manière à ce que :

$$\frac{v_{hyp}(f)}{v_{opt}(\lambda)} \cdot \frac{1 + \dfrac{\tan\theta}{\cos\alpha(\lambda)}}{1 + \tan\theta . \tan\alpha(\lambda)} = 1$$

Dans ce mode de fonctionnement, on peut associer à chaque fréquence $f_i$ une longueur d'onde $\lambda_i$ telle que son angle de diffraction $\alpha_i$ par le dispositif 5 réalise l'accord des trajets optique et hyperfréquence. Il est également possible que chaque longueur d'onde $\lambda_i$ porte l'ensemble des fréquences. Dans ce cas, seule la fréquence $f_i$ correspondant à $\lambda_i$ sera détectée efficacement.

Le photodétecteur de l'invention est applicable à un générateur de signaux hyperfréquences. Ainsi, sur la figure 6a, un signal hyperfréquence de puissance relativement élevée peut être recueilli et transmis sur le câble coaxial.

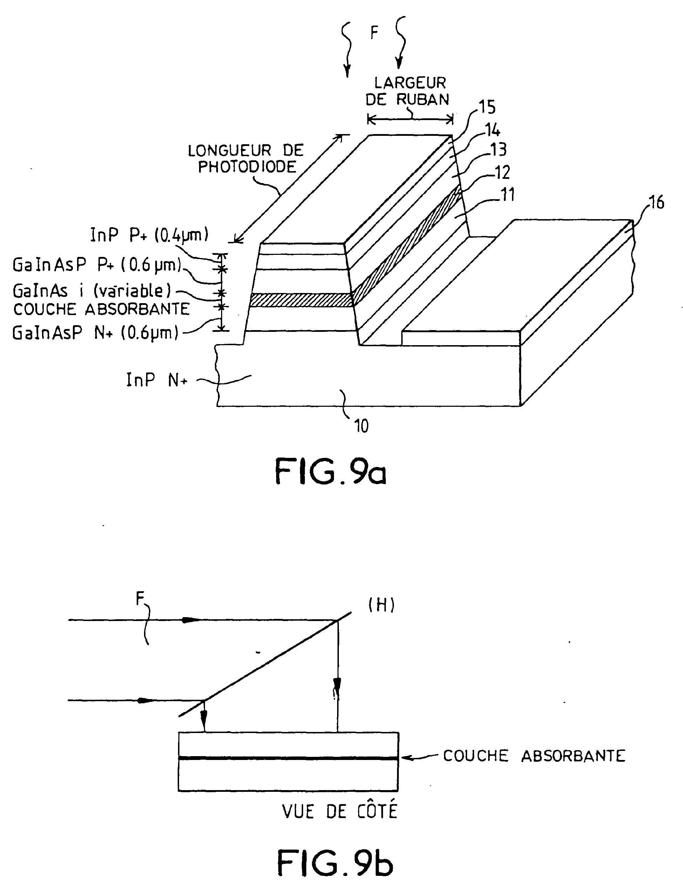

Selon une variante de réalisation représenté en figures 9a et 9b, l'élément en matériau photoconducteur 1 a la forme d'une diode pin réalisée sous forme de couches de semiconducteurs dopées p, i et n.

La structure de la figure 9a comporte sur un substrat 10 dopé n$^+$, un empilement 11, 12, 13 constituant la diode PIN, une couche de prise de contact dopé p$^+$ et une électrode transparente 15. Le substrat comporte en outre une électrode 16. Le faisceau F est incident sur la face supérieure de la photodiode c'est-à-dire sur l'électrode transparente 15 (voir figure 9b).

La structure est par exemple une hétérojonction du type InP/GaInAsP/GaInAs fonctionnant à la longueur d'onde optique de 1,3 $\mu$m.

Il est bien évident que conformément à ce qui a été décrit précédemment, l'électrode 15 a une forme allongée. Entre une extrémité de 15 et de l'électrode 16 est connectée une impédance d'adaptation et entre l'autre extrémité de 15 et l'électrode 16 est connectée la sortie du dispositif (câble coaxial).

L'utilisation d'une structure épitaxiée autorise un fonctionnement à haute fréquence (> 20 GHz) sans subir les non-linéarités rencontrées dans les structures MSM. Ces non-linéarités proviennent de la non uniformité du champ électrique appliqué qui résulte du déploiement en géométrie coplanaire des électrodes.

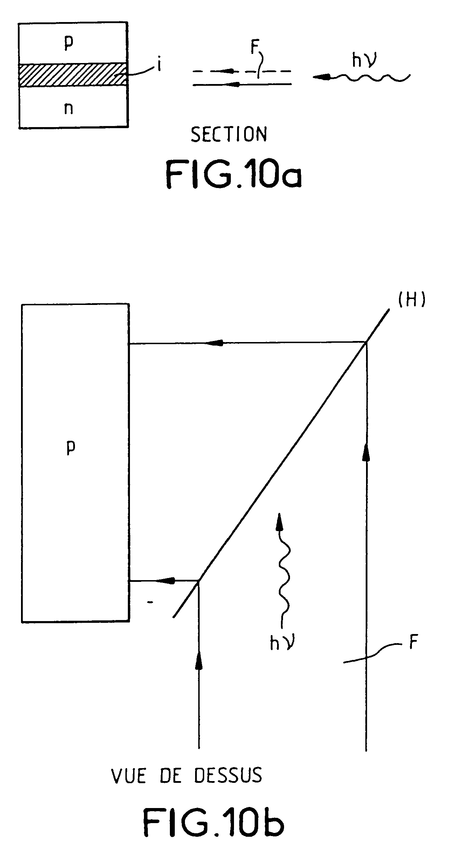

Dans cette variante, on peut conserver la structure de photodiode pin épitaxiée et on peut prévoir l'éclairement non plus par le dessus mais par la tranche (figure 10).

Dans cette configuration, on cumule l'avantage d'avoir une structure épitaxiée permettant l'application d'un champ électrique uniforme ainsi qu'un transport des charges perpendiculaires au flux optique. Ce dernier permet d'optimiser séparément la longueur d'absorption et l'épaisseur de la zone intrinsèque.

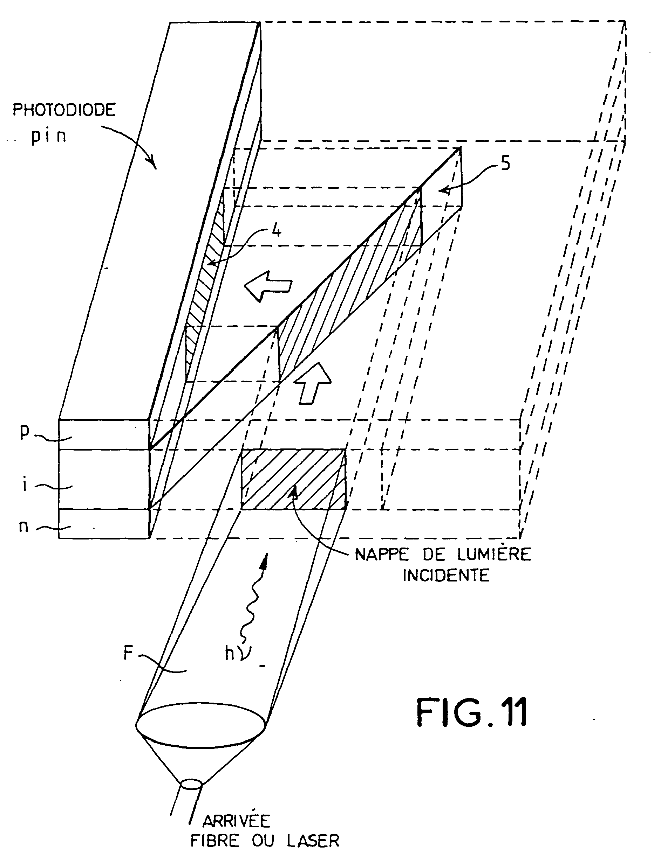

Un tel dispositif peut être réalisé sous forme intégrée (voir figure 11) alors composée de la photodiode pin épitaxiée et du composant diffractif 5 gravé dans le substrat, dans le même plan que la zone sensible de la photodiode. Une nappe de lumière de section rectangulaire est dirigée vers 5 pour y être progressivement diffractée vers la photodiode. Les conditions de sommation en phase le long du guide sont similaires à celles obtenues en propagation libre. La vitesse de propagation de la lumière est toutefois diminuée de l'indice optique du guide.

Le dispositif de l'invention est applicable au traitement d'impulsions et notamment à la compression et l'expansion temporelle d'impulsions.

Les impulsions sont portées par le faisceau lumineux F.

Dans la configuration du dispositif de la figure 3a par exemple, lorsque l'onde optique se dirige vers le détecteur sous incidence normale (figure 8a), l'accord des trajets optique et hyperfréquence est supposé réalisé, l'angle θ ayant été convenablement choisi. Dans ce cas, on transfère l'impulsion de l'onde optique vers le signal hyperfréquence à l'identique.

En inclinant le photodétecteur par rapport à la direction du faisceau incident, on modifie le trajet optique des différents portions du faisceau optique par rapport au trajet hyperfréquence.

Par exemple, pour $\beta < 0$, on comprime l'impulsion (figure 8b) et pour $\beta > 0$, on réalise l'extension de l'impulsion (figure 8c).

## Revendications

1. Photodétecteur à ondes progressives comprenant un élément en matériau photoconducteur (1), deux électrodes (2, 3) de formes allongées situées de part et d'autre du matériau photoconducteur, une impédance de charge reliant deux extrémités des électrodes, des moyens de détection électriques connectés aux deux autres extrémités des électrodes, et des moyens d'éclairement (5) permettant de transmettre un faisceau lumineux à détecter sur ladite face d'éclairement (4), **caractérisé en ce que** :

   - l'élément en matériau photoconducteur (1) possède une face d'éclairement (4) dont une grande dimension est de forme allongée parallèle aux formes allongées des électrodes ; et
   - lesdits moyens d'éclairement permettent d'étaler ledit faisceau de façon que l'onde lumineuse soit déphasée sur la face d'éclairement selon la grande dimension de ladite face,

   ledit faisceau lumineux présentant une modulation rapide en amplitude.

2. Photodétecteur selon la revendication 1, **caractérisé en ce que** les électrodes sont situées sur une face (10) de l'élément photoconducteur (1) et que ladite face d'éclairement est située entre les deux électrodes.

3. Photodétecteur selon la revendication 1, **caractérisé en ce que** l'élément photoconducteur est une couche photoconductrice et **en ce que** les électrodes sont situées sur deux faces opposées (10, 11) de la couche photoconductrice et que la face d'éclairement est une tranche de la couche photoconductrice.

4. Photodétecteur selon la revendication 2 ou 3, **caractérisé en ce que** des moyens d'étalement du faisceau lumineux comportent un dispositif de réflexion ou de diffraction recevant le faisceau d'entrée et le réfléchissant ou le diffractant sur la face d'éclairement.

5. Photodétecteur selon la revendication 4, **caractérisé en ce que** le dispositif de diffraction est un dispositif holographique fonctionnant en réflexion ou en transmission.

6. Photodétecteur selon la revendication 1, **caractérisé en ce que** le faisceau lumineux (F) est une onde plane.

7. Photodétecteur selon la revendication 1, **caractérisé en ce que** le faisceau lumineux éclairant la face (4) donne lieu sur celle-ci à un déplacement d'une onde lumineuse à une première vitesse ($v_{opt}$) et la création d'une onde de fréquence dans le matériau photoconducteur se déplaçant à une deuxième vitesse.

8. Photodétecteur selon la revendication 7, **caractérisé en ce que** la première vitesse et la deuxième vitesse sont égales.

9. Photodétecteur selon l'une des revendications précédentes, **caractérisé en ce que** le faisceau lumineux à détecter est modulé à une fréquence hyperfréquence.

10. Photodétecteur selon la revendication 7, **caractérisé en ce que** les moyens d'éclairement (5) sont réglables de façon à adapter les première et deuxième vitesses de façon à réaliser une compression ou une expansion d'impulsion.

11. Photodétecteur selon la revendication 4, **caractérisé en ce que** le dispositif de réflexion ou de diffraction est orientable.

12. Photodétecteur selon la revendication 9, **caractérisé en ce que** le faisceau lumineux d'entrée est multi-longueurs d'ondes et **en ce que** chaque longueur d'onde ($\lambda_i$) est modulée à une fréquence déterminée ($f_i$).

13. Photodétecteur selon la revendication 9, **caractérisé en ce que** le faisceau lumineux d'entrée est multi-longueurs d'ondes et **en ce que** les différentes longueurs d'ondes sont modulées par une même fréquence.

14. Générateur de signaux hyperfréquences, **caractérisé en ce qu'**il comporte un photodétecteur selon l'une quelconque des revendications 9, 12 ou 13.

**Claims**

1. Travelling-wave photodetector comprising an element (1) made of photoconducting material, two electrodes (2, 3) of elongate shape located on each side of the photoconducting material, a load impedance connecting two ends of the electrodes, electrical detection means connected to the two other ends of the electrodes, and illumination means (5) for transmitting a light beam to be detected on said illumination face (4), **characterized in that**:

   - the element (1) made of photoconducting material possesses an illumination face (4), a long dimension of which is of elongate shape parallel to the elongate shapes of the electrodes; and
   - said illumination means make it possible to spread said beam so that the light wave is phase-shifted on the illumination face along the long dimension of said face,

   said light beam exhibiting rapid amplitude modulation.

2. Photodetector according to Claim 1, **characterized in that** the electrodes are located on one face (10) of the photoconducting element (1) and **in that** said illumination face is located between the two electrodes.

3. Photodetector according to Claim 1, **characterized in that** the photoconducting element is a photoconducting layer, **in that** the electrodes are located on two opposed faces (10, 11) of the photoconducting layer and **in that** the illumination face is an edge of the photoconducting layer.

4. Photodetector according to Claim 2 or 3, **characterized in that** the means for spreading the light beam comprise a reflection or diffraction device that receives the entry beam and reflects or diffracts it on the illumination face.

5. Photodetector according to Claim 4, **characterized in that** the diffraction device is a holographic device operating in reflection or in transmission.

6. Photodetector according to Claim 1, **characterized in that** the light beam (B) is a plane wave.

7. Photodetector according to Claim 1, **characterized in that** the light beam illuminating the face (4) gives rise, on said face, to the propagation of a light wave at a first velocity ($v_{opt}$) and the creation in the photoconducting material of a frequency wave propagating at a second velocity.

8. Photodetector according to Claim 7, **characterized in that** the first velocity and the second velocity are the same.

9. Photodetector according to one of the preceding claims, **characterized in that** the light beam to be detected is modulated at a microwave frequncy.

10. Photodetector according to Claim 7, **characterized in that** the illumination means (5) are controllable so as to adapt the first and second velocities in order to carry out a pulse compression or expansion.

11. Photodetector according to Claim 4, **characterized in that** the reflection or diffraction device can be oriented.

12. Photodetector according to Claim 9, **characterized in that** the entry light beam has multiple wavelengths and **in that** each wavelength ($\lambda_i$) is modulated at a defined frequency ($f_i$).

13. Photodetector according to Claim 9, **characterized in that** the entry light beam has multiple wavelengths and **in that** the various wavelengths are modulated by the same frequency.

14. Microwave signal generator, **characterized in that** it includes a photodetector according to any one of Claims 9, 12 and 13.

**Patentansprüche**

1. Wanderwellen-Photodetektor, der ein Element aus photoleitendem Werkstoff (1), zwei Elektroden (2, 3) länglicher Form, die zu beiden Seiten des photoleitenden Werkstoffs angeordnet sind, eine zwei Enden der Elektroden verbindende Lastimpedanz, elektrische Erfassungsmittel, die mit den zwei anderen Enden der Elektroden verbunden sind, und Beleuchtungsmittel (5) aufweist, die es ermöglichen, einen zu erfassenden Lichtstrahl auf die Beleuchtungsseite (4) zu übertragen, **dadurch gekennzeichnet, dass**:

   - das Element aus photoleitendem Werkstoff (1) eine Beleuchtungsseite (4) aufweist, von der eine große Abmessung eine längliche Form parallel zu den länglichen Formen der Elektroden hat; und
   - die Beleuchtungsmittel es ermöglichen, den Strahl so auszubreiten, dass die Lichtwelle auf der Beleuchtungsseite gemäß der großen Abmessung der Seite phasenverschoben ist,

   wobei der Lichtstrahl eine schnelle Amplitudenmodulation aufweist.

2. Photodetektor nach Anspruch 1, **dadurch gekennzeichnet, dass** die Elektroden sich auf einer Seite (10) des photoleitenden Elements (1) befinden, und dass die Beleuchtungsseite sich zwischen den zwei Elektroden befindet.

3. Photodetektor nach Anspruch 1, **dadurch gekennzeichnet, dass** das photoleitende Element eine photoleitende Schicht ist, und dass die Elektroden sich auf zwei entgegengesetzten Seiten (10, 11) der photoleitenden Schicht befinden, und dass die Beleuchtungsseite eine Schmalseite der photoleitenden Schicht ist.

4. Photodetektor nach Anspruch 2 oder 3, **dadurch gekennzeichnet, dass** Ausbreitungsmittel des Lichtstrahls eine Reflektions- oder Beugungsvorrichtung aufweisen, die den Eingangsstrahl empfängt und ihn auf der Beleuchtungsseite reflektiert oder beugt.

5. Photodetektor nach Anspruch 4, **dadurch gekennzeichnet, dass** die Beugungsvorrichtung eine holographische Vorrichtung ist, die im Reflektions- oder im Übertragungsbetrieb arbeitet.

6. Photodetektor nach Anspruch 1, **dadurch gekennzeichnet, dass** der Lichtstrahl (F) eine ebene Welle ist.

7. Photodetektor nach Anspruch 1, **dadurch gekennzeichnet, dass** der die Seite (4) beleuchtende Lichtstrahl auf dieser Seite zu einer Verschiebung einer Lichtwelle mit einer ersten Geschwindigkeit ($v_{opt}$) und zur Erzeugung einer Frequenzwelle im photoleitenden Werkstoff führt, die sich mit einer zweiten Geschwindigkeit bewegt.

8. Photodetektor nach Anspruch 7, **dadurch gekennzeichnet, dass** die erste Geschwindigkeit und die zweite Geschwindigkeit gleich sind.

9. Photodetektor nach einem der vorhergehenden Ansprüche, **dadurch gekennzeichnet, dass** der zu erfassende Lichtstrahl mit einer Höchstfrequenz-Frequenz moduliert ist.

10. Photodetektor nach Anspruch 7, **dadurch gekennzeichnet, dass** die Beleuchtungsmittel (5) so einstellbar sind, dass die erste und die zweite Geschwindigkeit angepasst werden, um eine Impulskompression oder Impulsdehnung zu erzeugen.

11. Photodetektor nach Anspruch 4, **dadurch gekennzeichnet, dass** die Reflektions- oder Beugungsvorrichtung ausrichtbar ist.

12. Photodetektor nach Anspruch 9, **dadurch gekennzeichnet, dass** der Eingangslichtstrahl Mehrwellenlängen aufweist, und dass jede Wellenlänge ($\lambda_i$) mit einer bestimmten Frequenz ($f_i$) moduliert ist.

13. Photodetektor nach Anspruch 9, **dadurch gekennzeichnet, dass** der Eingangslichtstrahl Mehrwellenlängen aufweist, und dass die verschiedenen Wellenlängen mit der gleichen Frequenz moduliert sind.

14. Höchstfrequenzsignalgenerator, **dadurch gekennzeichnet, dass** er einen Photodetektor nach einem der Ansprüche 9, 12 oder 13 aufweist.

FIG.1

FIG.2

**FIG.3a**

**FIG.3c**

**FIG.3b**

EP 0 812 022 B1

FIG.4

FIG.5

FIG.7

PHOTODÉTECTEUR

FIG.6a

FIG.6b

SIGNAL OPTIQUE

FIG. 8a

FIG. 8b

FIG. 8c

EP 0 812 022 B1

F

LARGEUR
DE RUBAN

15
14
13
12
11

16

LONGUEUR DE
PHOTODIODE

InP P+ (0.4µm)

GaInAsP P+ (0.6µm)

GaInAs i (variable)
COUCHE ABSORBANTE

GaInAsP N+ (0.6µm)

InP N+

10

## FIG.9a

F

(H)

COUCHE ABSORBANTE

VUE DE CÔTÉ

## FIG.9b

p

i

n

F

hν

SECTION

# FIG.10a

(H)

p

-

hν

F

VUE DE DESSUS

# FIG.10b

PHOTODIODE
pin

5

4

p

i

n

NAPPE DE LUMIÈRE
INCIDENTE

F

hν

FIG.11

ARRIVÉE
FIBRE OU LASER

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **K.S. GIBONEY et al.** *Photon. Tech. Letters,* 1992, vol. 4, 1363-1365